Europäisches Patentamt

**European Patent Office**

**Office européen des brevets**

(11) Numéro de publication: **0 392 439**

**A1**

(12) **DEMANDE DE BREVET EUROPEEN**

(21) Numéro de dépôt: **90106815.5**

(51) Int. Cl.5: **G01R 15/02**

(22) Date de dépôt: **10.04.90**

(30) Priorité: **13.04.89 CH 1399/89**

(43) Date de publication de la demande:
**17.10.90 Bulletin 90/42**

(84) Etats contractants désignés:
**CH DE FR GB IT LI**

(71) Demandeur: **LIAISONS ELECTRONIQUES-MECANIQUES LEM S.A.**
**8, chemin des Aulx**
**CH-1228 Plan-les-Ouates(CH)**

(72) Inventeur: **Etter, Marcel**
**Chemin du Champ Gilbert 35**
**CH-1256 Troinex(CH)**

(74) Mandataire: **Hranitzky, Wilhelm Max et al**
**c/o WILLIAM BLANC & CIE Conseils en Propriété Industrielle SA 9, rue du Valais**
**CH-1202 Genève(CH)**

(54) **Dispositif à transformateur d'intensité de courant pour la mesure d'un courant électrique variable.**

(57) Le présent dispositif comporte un circuit électrique de mesure fournissant d'une part, à partir d'une cellule de Hall (5) qui est disposée dans l'entrefer (3) d'un circuit magnétique (2) couplé avec un conducteur primaire (1) pour le courant à mesurer, un premier signal de mesure ($U_s$) fonction du champs magnétique dans l'entrefer, et, d'autre part, un signal de mesure ($U_r$) fonction du courant induit dans un enroulement de mesure (4) couplé avec le circuit magnétique (2). Les deux signaux sont additionnés pour fournir une tension qui est une image fidèle du courant dans le conducteur primaire, ce courant pouvant être un courant impultionnel ou périodique à forme d'onde fortement asymétrique, ou un courant continu ou alternatif à basse fréquence avec une forte ondulation à fréquences élevées superposées.

FIG. 1

EP 0 392 439 A1

## DISPOSITIF A TRANSFORMATEUR D'INTENSITE DE COURANT POUR LA MESURE D'UN COURANT ELECTRIQUE VARIABLE

La présente invention concerne un dispositif à transformateur d'intensité de courant pour la mesure d'un courant électrique variable, dans lequel le transformateur d'intensité de courant comporte un circuit magnétique présentant au moins un entrefer muni d'un détecteur de champ magnétique, le circuit magnétique étant agencé pour pouvoir être couplé magnétiquement avec un conducteur pour le courant à mesurer et étant couplé magnétiquement avec au moins un enroulement de mesure.

Un tel dispositif est décrit, par exemple, dans la demande de brevet européen N° 0 194 225.

Ces dispositifs connus travaillent selon le principe de la compensation des champs magnétiques engendrés, d'une part, par le courant à mesurer et, d'autre part, par un courant de mesure que l'on fait circuler dans l'enroulement de mesure.

Il s'avère que dans certaines applications, telles que, par exemple, la mesure de courants impulsionnels ou périodiques à forme d'onde fortement asymétrique, ou la mesure de courants d'enclenchement de réseaux alternatifs, un transformateur d'intensité usuel se sature et n'est donc pas utilisable. D'autre part, il est souvent souhaitable de pouvoir mesurer des courants continus ou alternatifs à basse fréquence avec une forte ondulation à fréquences élevées superposée, et de disposer, à cet effet, d'un dispositif relativement simple, économique et peu encombrant.

L'invention vise à fournir un dispositif répondant à ce besoin.

A cet effet, le dispositif selon l'invention comporte un circuit électrique de mesure agencé pour fournir, d'une part, un premier signal de mesure ($U_S$) fonction du champ magnétique dans l'entrefer dudit circuit magnétique et, d'autre part, un second signal de mesure ($U_R$) fonction du courant dans l'enroulement de mesure.

Le détecteur de champ magnétique est de préférence une cellule de Hall, le circuit de mesure étant agencé pour fournir comme premier signal de mesure une première tension de mesure ($U_S$) proportionnelle, de manière réglable, au champ magnétique dans l'entrefer, le second signal de mesure étant une tension ($U_R$) apparaissant aux bornes d'une résistance de mesure branchée en série avec l'enroulement de mesure. Le circuit de mesure est, de préférence, agencé pour additionner les première et seconde tensions de mesure. Dans un tel dispositif, une particularité importante consiste à prévoir que le circuit de mesure soit agencé et réglé de telle façon qu'un courant de référence sinusoïdal passant dans ledit conducteur pour le courant à mesurer produit, à l'état non-branché de l'enroulement de mesure, une tension de mesure égale à la tension théorique que produirait un transformateur d'intensité idéal, sans entrefer, aux bornes de la résistance de mesure.

Selon une forme d'exécution préférentielle, la cellule de Hall, connectée par une borne d'alimentation d'entrée à un générateur de courant d'excitation, est reliée, par une borne d'excitation de sortie, à une borne de sortie d'un amplificateur opérationnel ayant deux entrées, l'une de ces entrées étant reliée à un potentiel de référence pour la mesure (masse), et l'autre de ces entrées étant reliée à l'une des bornes de mesure de la cellule de Hall, de sorte que cette borne de mesure est maintenue au potentiel de référence et que la tension de mesure fournie par la cellule apparaît à l'autre borne de mesure par rapport audit potentiel de référence.

Le présent dispositif comporte avantageusement un amplificateur à gain réglable à une entrée duquel est appliquée la tension de mesure fournie par la cellule de Hall, et une sortie duquel est connectée à une borne de la résistance de mesure, l'autre borne de cette résistance constituant la borne de sortie du circuit de mesure.

Selon une variante d'exécution, la résistance de mesure est connectée à une borne de mesure de la cellule de Hall, cette cellule étant alimentée par un générateur de courant fournissant un courant d'excitation réglable.

Dans le dispositif selon l'invention, le circuit magnétique peut comporter deux ou plusieurs entrefers munis chacun d'un détecteur de champ magnétique, fournissant un signal fonction du champ magnétique dans l'entrefer correspondant, le circuit de mesure étant agencé pour effectuer l'addition des signaux fournis par ces détecteurs et du second signal de mesure fonction du courant dans l'enroulement de mesure.

Selon une forme d'exécution particulièrement importante, le dispositif selon l'invention comporte un circuit de sécurité, agencé pour détecter le dépassement d'au moins un seuil de la tension de mesure fournie par la cellule de Hall et pour fournir un signal de défaut lors d'un tel dépassement.

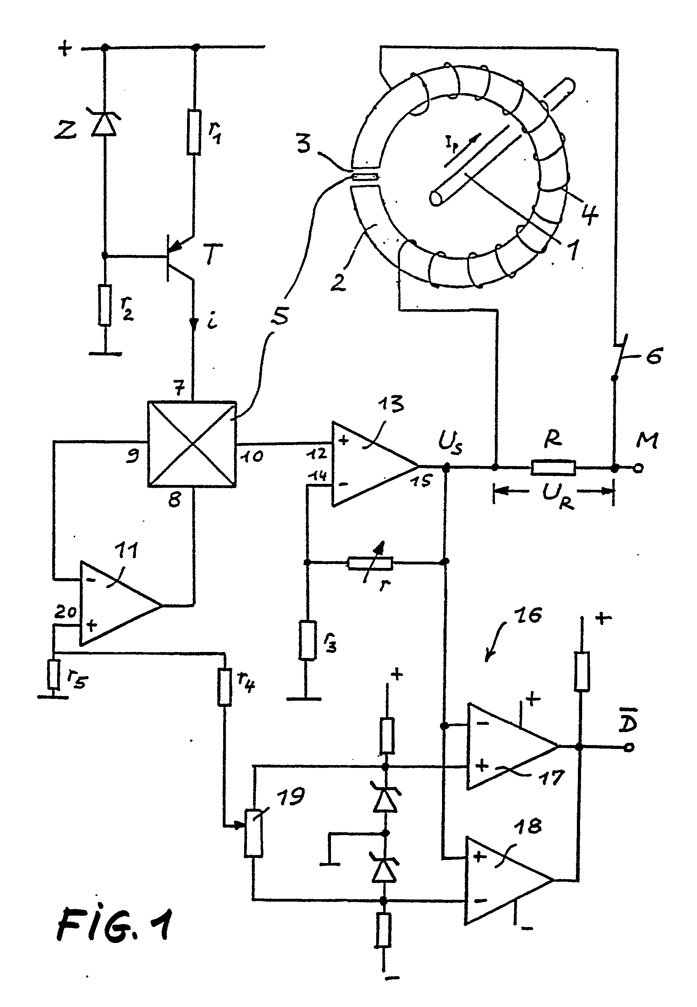

D'autres caractéristiques, avantages et particularités de l'invention apparaîtront à la lumière de la description suivante d'un exemple de mise en oeuvre illustré dans le dessin annexé, dont

l'unique fig. 1 montre, de façon schématique, un transformateur d'intensité de courant et un circuit de mesure d'un dispositif selon l'invention.

Dans le schéma de la fig. 1, le courant primaire à mesurer $I_P$ circule dans un conducteur 1 qui est entouré, transversalement, par un circuit magnétique 2 ayant un entrefer 3. Ce circuit magnétique peut être constitué, par exemple, par un tore en un matériau ayant une bonne perméabilité magnétique ou par des tôles empilées formant une structure feuilletée à la manière d'un noyau de transformateur. Un enroulement de mesure 4 est disposé sur ce circuit magnétique et est branché, par l'intermédiaire d'un dispositif de connexion représenté symboliquement par un interrupteur 6, à une résistance de mesure R. Une cellule de Hall 5 est placée dans l'entrefer 3, de manière à être soumise à l'effet du champ magnétique apparaissant dans cet entrefer.

La cellule de Hall 5 est représentée séparément avec ses connexions dans le schéma électrique de la fig. 1. Un courant d'excitation i est fourni à la cellule 5 par l'intermédiaire d'un générateur de courant représenté, à titre d'exemple, par le circuit comprenant un transistor T, des résistances $r_1$ et $r_2$ et une diode Zener Z, connectés selon la fig. 1 à une première borne d'alimentation 7 de la cellule. Le potentiel de la seconde borne d'alimentation 8 de la cellule est contrôlé continuellement par un amplificateur opérationnel 11 monté selon la fig. 1, de telle sorte qu'une première borne de mesure 9 de la cellule de Hall, reliée à une entrée (-) de l'amplificateur 11, soit maintenue au potentiel appliqué à une deuxième entrée (+) de cet amplificateur, ce potentiel constituant un potentiel de référence, c'est-à-dire la masse dans l'exemple de la fig. 1. A la seconde borne de mesure 10 de la cellule de Hall apparaît ainsi, par rapport à la masse, une tension de mesure proportionnelle au champ magnétique H régnant dans l'entrefer 3.

La borne de sortie 10 est connectée à une première borne d'entrée 12 d'un amplificateur opérationnel 13, dont une deuxième borne d'entrée 14 est connectée à un point intermédiaire d'un diviseur de tension branché entre la masse et une borne de sortie 15 de cet amplificateur opérationnel 13. Le diviseur de tension comprend, en l'occurrence, une résistance fixe $r_3$ et une résistance variable r permettant de régler le niveau de la tension de mesure $U_S$ apparaissant à la sortie 15, autrement dit d'ajuster le facteur de proportionalité entre cette tension et le champ magnétique H.

Lorsque le courant à mesurer $I_P$ comprend une composante continue et une composante variable, cette dernière induit une force contre-électromotrice dans l'enroulement 4. Cet enroulement étant branché sur la résistance R, les ampère-tours correspondants $AT_S$, les ampère-tours primaires $AT_P$, c'est-à-dire en l'occurrence $I_P$, et le champ magnétique H sont liés par la relation $AT_P = H.L + AT_S$, L étant la longueur de l'entrefer. La tension $U_S$ fournit ainsi une mesure de la composante H.L du courant primaire, cette composante servant à magnétiser le circuit magnétique, c'est-à-dire en fait à établir le flux dans l'entrefer, car la très haute perméabilité de la partie en fer du circuit permet de négliger la force magnétomotrice nécessaire à la circulation du flux dans le reste du circuit. Quant à la tension $U_R$ aux bornes de la résistance R, elle mesure la composante du courant primaire compensée par les ampère-tours secondaires résultant de la variation du flux magnétique.

Pour étalonner la tension $U_S$ par rapport à la tension $U_R$, on utilise un courant primaire de référence continu ou sinusoïdal. Pour l'étalonnage en courant sinusoïdal, on débranche l'enroulement 4 en ouvrant l'interrupteur 6, de manière que la mesure du courant ne se fasse que par la mesure du champ dans l'entrefer. On règle ensuite la tension $U_S$ en réglant le gain de l'amplificateur 13 au moyen de la résistance r, de façon que l'amplitude de US soit égale à la valeur théorique de l'amplitude de la tension $U_R$ que fournirait un transformateur d'intensité idéal, sans entrefer, soit $U_S = R. I_P/N_S$, où $N_S$ est le nombre de spires de l'enroulement 4. Les tensions $U_R$ et $U_S$ peuvent ainsi être additionnées pour fournir une mesure de l'intensité totale d'un courant ayant une composante continue. Dans le schéma de la fig. 1, la tension de mesure totale apparaît à une borne M, la résistance R étant montée entre les bornes 15 et M.

Selon une variante non représentée, la résistance de mesure R est connectée directement à la cellule de Hall, à la borne 10 de celle-ci, et cette cellule est alimentée par un générateur de courant fournissant un courant d'excitation réglable, permettant de régler la tension de sortie de la cellule.

Il serait également possible de relier une borne de la résistance R à la masse et d'additionner la tension $U_R$ et la tension de sortie de la cellule de Hall, amplifiée ou non, à l'aide de résistances adéquates connectées à l'entrée "-" d'un amplificateur opérationnel, selon une méthode usuelle. Cependant, le fait de connecter la résistance R en série avec la tension de mesure $U_S$ présente l'avantage de ne pas déformer le signal de mesure $U_R$ par la limitation en amplitude et en bande passante, de l'amplificateur opérationnel.

Un tel dispositif est particulièrement avantageux pour la mesure précise de courants impulsionnels ou de courants de court-circuit, de forte amplitude, ou lorsqu'on est en présence d'un courant primaire élevé ayant une composante continue relativement faible, ou encore dans le cas de courants primaires alternatifs ayant une composante continue pendant une durée limitée, tels que les courants d'enclenchement de réseaux alternatifs.

Le schéma de la fig. 1 montre, en outre, l'agencement d'un circuit de sécurité, désigné dans son ensemble par 16, destiné à détecter le dépassement d'un seuil, dans le sens d'une polarité ou de l'autre, dans la tension de mesure fournie par la cellule de Hall. A cet effet, la borne 15 est connectée à des entrées respectivement "-" et "+" de deux comparateurs 17,18, les entrées correspondantes de signe opposé de ces comparateurs étant reliées aux bornes d'un montage en série de deux diodes Zener, dont le point de connexion commun est connecté à la masse et dont les bornes extérieures sont reliées respectivement, par l'intermédiaire de résistances, aux bornes positive et négative de la source de tension d'alimentation du circuit. En parallèle à ces diodes Zener est connecté un potentiomètre 19, dont le curseur est relié, par l'intermédiaire d'une résistance $r_4$ à l'entrée 20 de l'amplificateur opérationnel 11, une résistance $r_5$ de faible valeur étant branchée entre cette entrée et la masse. Ce potentiomètre permet d'annuler la tension de décalage (offset) du signal $U_S$ en l'absence de courant primaire, tension provoquée par la somme des tensions de décalage de la cellule 5 et des amplificateurs 11 et 13.

Les bornes de sortie des comparateurs 17,18 constitués par des transistors à collecteur ouvert, sont connectées ensemble et, par l'intermédiaire d'une résistance, à la borne positive de la source de tension d'alimentation. Chaque comparateur est agencé de façon à conduire lorsque la tension de mesure qui lui est appliquée dépasse le seuil défini par la tension de la diode Zener correspondante dans le sens de la polarité de cette tension. Ainsi apparaît un signal de sortie, tel que, dans le circuit représenté, un signal par défaut D, négatif, qui indique, par exemple, une saturation du circuit magnétique ou le travail dans une zone de la cellule de Hall qui n'est plus linéaire.

Selon les applications, il peut être avantageux de diviser le circuit magnétique en deux branches, de manière à obtenir un circuit pouvant être ouvert pour permettre l'introduction de conducteurs primaires à l'intérieur du circuit. Dans ce cas, le circuit magnétique aura, par exemple, deux entrefers dans chacun desquels sera placée une cellule de Hall, les tensions de mesure de ces cellules, individuellement ajustables, étant additionnées dans le circuit de mesure. Bien entendu, l'enroulement de mesure pourra être réparti sur les deux branches du circuit magnétique, et celles-ci peuvent être articulées à la manière d'un pince ampèremétrique, par exemple.

Le nombre d'entrefers et de cellules de Hall correspondantes n'est en fait pas limité à deux et sera, de préférence, supérieur à deux dans le cas de la mesure de très forts courants.

Dans le cas d'un dispositif à plusieurs cellules, on effectue une addition des tensions des différentes cellules, par exemple, en reliant la borne 10 d'une première cellule à l'entrée du circuit d'alimentation de la cellule suivante, c'est à dire à une borne correspondant à la borne 20. Ainsi, le potentiel apparaissant à la sortie, telle que 10, de chaque cellule sert de potentiel de référence pour la cellule suivante et la somme des tensions de mesure de toutes les cellules apparait à la sortie de la dernière cellule.

D'un autre côté, dans le cas de la mesure de courants relativement faibles, on utilisera de préférence un conducteur primaire formé de plusieurs spires pour améliorer la précision de la mesure de la composante continue.

## Revendications

1. Dispositif à transformateur d'intensité de courant pour la mesure d'un courant électrique variable, dans lequel le transformateur d'intensité de courant comporte un circuit magnétique présentant au moins un entrefer muni d'un détecteur de champ magnétique, le circuit magnétique étant agencé pour pouvoir être couplé magnétiquement avec un conducteur pour le courant à mesurer et étant couplé magnétiquement avec au moins un enroulement de mesure, caractérisé en ce qu'il comporte un circuit électrique de mesure agencé pour fournir, d'une part, un premier signal de mesure ($U_S$) fonction du champ magnétique dans l'entrefer (3) dudit circuit magnétique (2) et, d'autre part, un second signal de mesure ($U_R$) fonction du courant dans l'enroulement de mesure (4).

2. Dispositif selon la revendication 1, caractérisé en ce que le détecteur de champ magnétique est une cellule de Hall (5), le circuit de mesure étant agencé pour fournir comme premier signal de mesure une première tension de mesure ($U_S$) proportionnelle, de manière réglable, au champ magnétique dans l'entrefer (3), et en ce que ledit second signal de mesure est une tension ($U_R$) apparaissant aux bornes d'une résistance de mesure (R) branchée en série avec ledit enroulement de mesure (4).

3. Dispositif selon la revendication 2, caractérisé en ce que le circuit de mesure est agencé pour additionner les première et seconde tensions de mesure.

4. Dispositif selon la revendication 3, caractérisé en ce que le circuit de mesure est agencé et réglé de telle façon qu'un courant de référence sinusoïdal passant dans ledit conducteur (1) pour le courant à mesurer produit, à l'état non-branché de l'enroulement de mesure (4), une tension de mesure égale à la tension théorique que produirait un transformateur d'intensité idéal, sans entrefer, aux bornes de la résistance de mesure (R).

5. Dispositif selon la revendication 1, dans lequel le détecteur du champ magnétique est une cellule de Hall, ou selon l'une des revendications 2 à 4, la cellule de Hall étant connectée par une borne d'alimentation d'entrée et une borne d'alimentation de sortie à un générateur de courant d'excitation, caractérisé en ce que ladite borne d'alimentation de sortie (8) de la cellule de Hall (5) est reliée à une borne de sortie d'un amplificateur opérationnel (11) ayant deux entrées ( +,-), l'une de ces entrées ( + ) étant reliée à un potentiel de référence pour la mesure (masse), et l'autre de ces entrées (-) étant reliée à l'une des bornes de mesure (9) de la cellule de Hall (5), de sorte que cette borne de mesure (9) est maintenue au potentiel de référence et que la tension de mesure fournie par la cellule apparaît à l'autre borne de mesure (10) par rapport audit potentiel de référence.

6. Dispositif selon l'une des revendications 3 ou 4, ou selon les revendications 3 et 5 ou 4 et 5, caractérisé en ce qu'il comporte un amplificateur à gain réglable (13), à une entrée (12) duquel est appliquée la tension de mesure fournie par la cellule de Hall (5), et une sortie (15) duquel est connectée à une borne de la résistance de mesure (R), l'autre borne de cette résistance constituant la borne de sortie (M) du circuit de mesure.

7. Dispositif selon l'une des revendications 3 ou 4, ou selon les revendications 3 et 5 ou 4 et 5, caractérisé en ce que la résistance de mesure (R) est connectée à une borne de mesure (10) de la cellule de Hall (5), cette cellule étant alimentée par un générateur de courant fournissant un courant d'excitation réglable.

8. Dispositif selon l'une des revendications précédentes, caractérisé en ce que le circuit magnétique (2) comporte deux ou plusieurs entrefers munis chacun d'un détecteur de champ magnétique, fournissant chacun un signal fonction du champ magnétique dans l'entrefer correspondant, le circuit de mesure étant agencé pour effectuer l'addition des signaux fournis par ces détecteurs et du second signal de mesure ($U_R$) fonction du courant dans l'enroulement de mesure.

9. Dispositif selon l'une des revendications 2 à 8, caractérisé en ce qu'il comporte un circuit de sécurité (16), agencé pour détecter le dépassement d'au moins un seuil de la tension de mesure fournie par la cellule de Hall (5) et pour fournir un signal de défaut lors d'un tel dépassement.

FIG. 1

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| D,X | EP-A-0 194 225 (LEM) <br> * Résumé; figure 1 * <br> --- | 1-5 | G 01 R 15/02 |
| X | EP-A-0 050 705 (GRUNDIG) <br> * Résumé; figure 3 * <br> --- | 1-5 | |
| E | EP-A-0 320 341 (AGENCE SPATIALE EUROPEENNE) <br> * Completement * <br> --- | 1-5 | |
| A | PATENT ABSTRACTS OF JAPAN, vol. 7, no. 113 (P-197)[1258], 18 mai 1983; & JP-A-58 33 167 (HIOKI DENKI K.K.) 26-02-1983 <br> ----- | | |

| | DOMAINES TECHNIQUES RECHERCHES (Int. Cl.5) |
|---|---|
| | G 01 R |

Le présent rapport a été établi pour toutes les revendications

| Lieu de la recherche | Date d'achèvement de la recherche | Examinateur |
|---|---|---|
| LA HAYE | 21-06-1990 | HOORNAERT W. |

EPO FORM 1503 03.82 (P0402)